Europäisches Patentamt

European Patent Office

Office européen des brevets

(19)

(11) **EP 1 170 803 A2**

(12) **EUROPEAN PATENT APPLICATION**

(43) Date of publication:
    **09.01.2002 Bulletin 2002/02**

(51) Int Cl.⁷: **H01L 29/78**, H01L 29/41,
    H01L 29/423, H01L 21/336

(21) Application number: **01304968.9**

(22) Date of filing: **07.06.2001**

(84) Designated Contracting States:
    **AT BE CH CY DE DK ES FI FR GB GR IE IT LI LU
    MC NL PT SE TR**
    Designated Extension States:
    **AL LT LV MK RO SI**

(30) Priority: **08.06.2000 US 590789**

(71) Applicant: **SILICONIX INCORPORATED**
    **Santa Clara, California 95054-0951 (US)**

(72) Inventors:
    • **Ng, Sze Him**
      **Campbell, California 95008 (US)**
    • **Korec, Jacek**
      **San Jose, California 95120 (US)**
    • **Giles, Frederik**
      **San Jose, California 95117 (US)**

(74) Representative: **Freeman, Jacqueline Carol**
    **W.P. THOMPSON & CO. Celcon House 289-293
    High Holborn
    London WC1V 7HU (GB)**

(54) **Trench gate MOSFET and method of making the same**

(57)     In a trench MOSFET a conductive shield gate is formed near the bottom of the trench. The shield gate is insulated from the overlying active gate and, depending on the use of the MOSFET, is connected to a constant voltage, such as ground. The shield gate reduces the capacitance between the active gate and the drain, thereby improving the ability of the MOSFET to operate at high frequencies, whether it is operated in its linear range or as a switching device.

FIG. 5

EP 1 170 803 A2

## Description

### Field Of The Invention

This invention relates to trench MOSFETs and in particular to trench MOSFETs that are suitable for high frequency signal amplification and switching.

### Background Of The Invention

One of the most important issues in a development of transistors for high-frequency operation is the reduction of their internal capacitances. For MOSFETs, these capacitances fall into three categories: the drain-to-gate capacitance ($C_{dg}$), also called the feedback capacitance ($C_{rss}$); the input capacitance ($C_{iss}$); and the output capacitance ($C_{oss}$). MOSFETs used for linear signal amplification should also be optimized in terms of maximum transconductance $g_{m,max}$ ($g_m = dI_{ds}/dV_{gs}$) and MOSFETs used for trench switching should have a minimum value of the product of their on-resistance ($R_{ds,on}$) and the gate charge (Qg) needed to be supplied to the gate in order to reach a pre-defined bias $V_{gs}$.

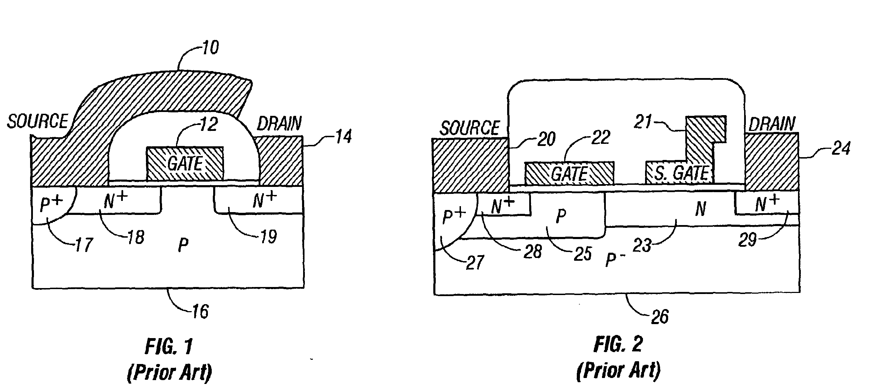

One of the better existing devices for linear amplification applications is the one described in Gordon Ma et al., "High Efficiency LDMOS Trench FET for Low Voltage Wireless Communications", Proceedings of IEDM'96, pp. 91-94. The Ma et al. device is schematically shown in the cross-sectional view of **Fig. 1.** In order to minimize the feedback capacitance $C_{rss}$ the metal forming the source contact metal 10 overlaps the gate 12 and shields the gate 12 against the drain contact metal 14 by the Faraday effect. The lateral MOSFET is formed in a P-type substrate having a source region 18 and a drain region 19. A P+ region 17 provides a good ohmic contact between the P-substrate and the source contact metal 10.

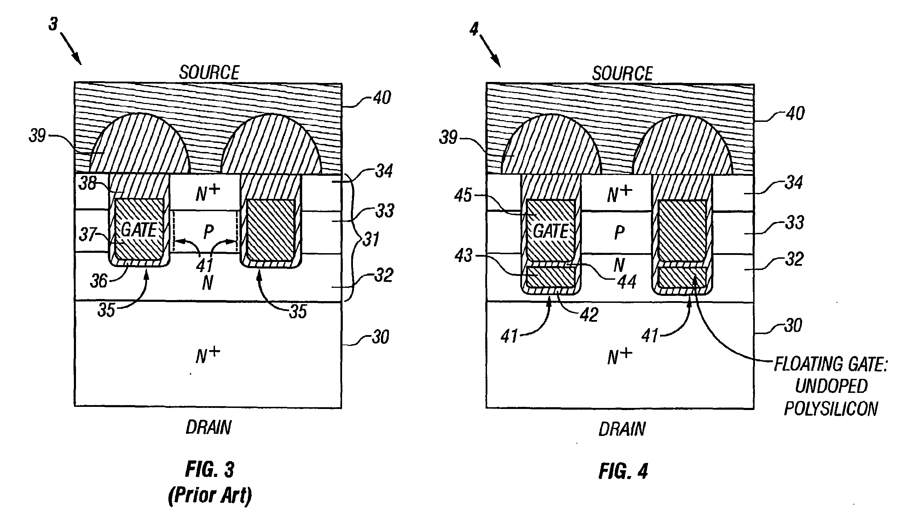

The use of a similar physical effect for lateral and vertical DMOS transistors is described in U.S. Patent No. 5,918,137 to Ng et al. There, the drain-to-gate capacitance is minimized by providing a "lateral shield ... between the drain and the gate with at least part of the shield formed on the gate oxide layer coplanar with the gate electrode." The shield electrode can be connected to "AC ground" or can have a "DC bias voltage to allow modulation of the device linearity." This structure is illustrated in **Fig. 2,** where a shield electrode (or "shield gate") 21 is shown interposed between the gate 22 and the drain contact metal 24. **Fig. 2** also shows an N+ source region 28, and a source contact metal 20, an N+ drain region 29, a lightly doped drain region 23, a P+ body contact region 27, and a P-body region 25 (which includes the channel). The structure is formed in a P- substrate 26.

Trench-MOSFETs, i.e., MOSFETs where the gate is located in a trench that is formed in a geometric pattern on the surface of the semiconductor die, are known to have a higher transconductance and a lower specific on-resistance than lateral and vertical DMOS-transistors. The structure of a prior art N-channel trench MOSFET 3 is presented in the cross-sectional view of **Fig. 3**. The MOSFET is formed on a heavily doped N+ substrate 30, on which is typically grown an epitaxial ("epi") layer 31, which is the drain of the device. The epi layer 31 is doped with N-type material which becomes a lightly doped drain region 32, into which a P-body region 33 and an N+ source region 34 are implanted. Trenches 35 extend from the surface of epi layer 31 downward through the N+ source region 34 and the P-body region 33 into the lightly doped drain region 32. The walls and bottoms of the trenches 35 are lined with a gate oxide layer 36, and the trenches contain a gate electrode 37 that is typically made of polysilicon. A thick oxide layer 38 is formed over the gate electrode 37 to provide good insulation from the N+ source region 34. Above the trenches 35 is a borophosphosilicate glass (BPSG) layer 39. A source contact metal 40 is in ohmic contact with N+ source regions 34. When the voltage of the gate 37 is raised, channel regions 41 along the side walls of the trenches 35 become inverted and allow a current to flow between the source and the drain.

A drain-to-gate capacitor $C_{gd}$ is formed between the gate electrode 37 and the N region 32, with the portion of the gate oxide layer 36 along the bottom of the trench representing the dielectric. In the trench structure, the drain-to-gate capacitor occupies a larger area per unit area of the die than in lateral devices. Large values of $C_{dg}$ and a resulting large $Q_g$ limit the applications of trench-MOSFETs at high frequencies. One possible way to reduce the drain-to-gate capacitance in a trench-MOSFET is to thicken the gate oxide layer at the bottom of the trench. However, there is no easy and cost effective process to incorporate a thick oxide at the bottom of the trench while maintaining the required thickness of the gate oxide along the side walls of the trench.

One possible solution is described in the above-referenced Application No **[Attorney Docket No. M-8200 US]** and is shown here for reference in **Fig. 4**. MOSFET 4 is similar to MOSFET 3 except that at the bottom of trenches 41 a sandwich structure is formed consisting of an oxide layer 42 at the bottom of the trench followed by a layer 43 of undoped polysilicon which in turn is isolated from the active gate 45 of the transistor by an oxide film 44. In this case, the undoped polysilicon layer 43 is not connected to any electrode and has a floating potential.

## Summary Of The Invention

A goal of the present invention is to improve the performance of a trench-MOSFET at high-frequency operation. This is achieved by in effect "splitting" the gate electrode within the trench into an active gate and a shield gate and placing the shield gate between the active gate and the drain of the transistor. The shield gate is made out of a conductive material and is connected to a constant DC potential, i.e., an AC ground. The shield gate can be made of a highly doped polysilicon and can be connected to the source electrode of the transistor.

In one aspect, the trench MOSFET comprises a semiconductor die having a trench formed in a principal surface of the die. The semiconductor die contains a source region of a first conductivity type located adjacent a side wall of the trench and the principal surface; a body region of a second conductivity type located adjacent the source region and the side wall of the trench; and a drain region of the first conductivity type adjacent a bottom of the trench. The trench contains a first insulating layer adjacent the bottom of the trench; a conductive shield gate overlying the first insulating layer and connected to a voltage source; a second insulating layer overlying the conductive layer; and a conductive active gate overlying the second insulating layer.

In one embodiment, the thickness of the oxide embedding the shield gate is made thicker (e.g. by a factor of 2 to 4) than the gate oxide separating the active gate from the body region. This further reduces the parasitic capacitances while maintaining a high value of the transconductance of the MOSFET.

This technique can be applied advantageously to a transistor designed as a Barrier-ACCUFET in accordance with the above-referenced Application No 09/476,320. In that case, the height of the shield gate should be at least 1/3, and preferably 1/2, of the width of the mesa width between the trenches. The Barrier-ACCUFET allows a use of a thicker gate oxide for the same electrical performance of the transistor and this in turn can reduce the parasitic capacitances of the device.

This invention also includes a method of fabricating a MOSFET in a semiconductor die comprising: forming a trench in the semiconductor die, the trench comprising a shield gate contact region, an active device region, and an active gate contact region; forming a first insulating layer at a bottom of the trench; introducing a first layer of conductive material over the first insulating layer; forming a mask over the first layer of conductive material in the shield gate contact region; etching the first layer of conductive material in the active device and active gate contact regions; forming a second insulating layer over the first layer of conductive material in the active device and active gate contact regions; introducing a second layer of conductive material in the active device and active gate contact regions, the second layer of conductive material being insulated from the first layer of conductive material; connecting the first layer of conductive material to a constant voltage; and connecting the second layer of conductive material to gate drive circuitry.

In another aspect, the method includes growing a first oxide layer on a side wall and a bottom of the trench; depositing a first polysilicon layer in the trench; forming a photoresist mask layer over the first polysilicon layer in the shield gate contact region; etching the first polysilicon layer in the active device and active gate contact regions such that a surface of the first polysilicon layer is located inside the trench; growing a second oxide layer over the first polysilicon layer in the active device and active gate contact regions; growing a gate oxide layer in the active device region; depositing a second polysilicon layer over the first polysilicon layer in the active device and active gate contact regions; forming a body region in the semiconductor die adjacent the gate oxide layer; and forming a source region in the semiconductor die.

After the deposition of the bottom oxide and the deposition of the first polysilicon layer (preferably $N^+$-doped), the first polysilicon layer is partially etched back to the level coincident with the main surface of the transistor. The first polysilicon layer is etched down to a pre-defined height of the shield gate and is used as a mask to etch away the first oxide layer from the side walls of the upper portion of the trench. The second oxide layer is grown thermally on the side walls of the trench above the shield gate and on the upper surface of the shield gate itself. The oxide grown on the top of the shield gate is typically substantially thicker than at the side walls of the trench because of a difference in the oxidation rate. A second layer of a doped polysilicon is deposited and etched back to a pre-determined level. In a preferred embodiment, the active gate formed in the second polysilicon overlaps the source region only slightly (e. g. by 0.1 um) in order to reduce the gate to source capacitance.

## Brief Description Of The Drawings

The invention can be best understood by reference to the following drawings, in which like elements are identified by like reference numerals. The drawings are not necessarily drawn to scale.

**Fig. 1** is a cross-sectional view of a prior art device of the kind described in Gordon Ma et al., "High Efficiency LDMOS Trench FET for Low Voltage Wireless Communications", Proceedings of IEDM'96, pp.91-94.

**Fig. 2** is a cross-sectional view of a MOSFET of the kind described in U.S. Patent No. 5,918,137 to Ng et al.

**Fig. 3** is a cross-sectional view of a prior art trench MOSFET.

**Fig. 4** is a cross-sectional view of a MOSFET of the kind described in Application No **[Attorney Docket No.**

**M-8200 US].**

**Fig. 5** is a cross-sectional view of a first embodiment of a MOSFET in accordance with this invention.

**Fig. 6** is a cross-sectional view of a Barrier MOSFET in accordance with the invention.

**Fig. 7** is a cross-sectional view defining various dimensions in a MOSFET according to the invention.

**Figs. 8** and **9A-9B** through **13A-13B** illustrate the steps of a process of fabricating a MOSFET according to this invention.

**Description Of The Invention**

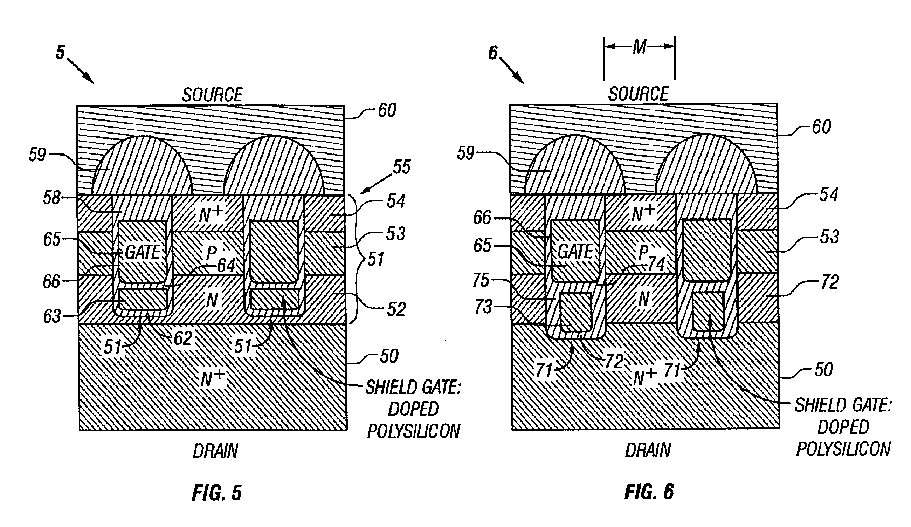

**Fig. 5** is a cross-sectional view of a first embodiment of a MOSFET in accordance with this invention. MOSFET 5 is formed in a semiconductor die 55 that includes an N+ substrate 50 and an overlying epi layer 51. Epi layer 51, when originally grown, is doped with N-type material relatively lightly as compared with N+ substrate 50. A P-body region 53 and an N+ source region 54 are later implanted into epi layer 51.. N+ substrate 50 and the N-type drift region 52 of epi layer 51 together form the drain of MOSFET 5. (The region adjacent the principal surface of the die 55 in which the trenches are formed is referred herein as the source; the region adjacent the other principal surface of the die 55 is referred to as the drain.)

It will be understood by those skilled in the art that trenches 51 are formed in a geometrical pattern on the surface of die 55. For example, trenches 51 could be in the form of longitudinal stripes or they could define a number of closed MOSFET cells in the form of a square or hexagon or any other arbitrary shape.

Within the trenches 61 are: an oxide layer 62 at the bottom of the trench which represents a first insulating layer; a shield gate 63 overlying the oxide layer 62; an oxide layer 64 which represents a second insulating layer overlying the shield gate 63; and an active gate 65 overlying the oxide layer 64. Overlying the active gate 65 is a thick oxide layer 58 which provides good insulation between the active gate 65 and the N+ source region 54. A gate oxide layer 66 lies adjacent a side wall of the trench 61, separating the active gate 65 from the P-body region 53. Above the trench 61 is a borophosphosilicate glass (BPSG) layer 59, which further insulates the active gate 65 from the N+ source region 54, and a source contact metal 60, which makes ohmic contact with the N+ source region 54. A drain contact metal on the opposite side of die 55 is not shown. A contact for the P-body region 53 is made in the third dimension from the plane of the drawing and is likewise not shown.

As described further below, shield gate 63 is heavily doped with N-type material and is connected electrically to a voltage source which can be a constant DC voltage, i.e., an AC ground. In one embodiment, the shield gate is connected to the N+ source region 54 via the source metal 60. Shield gate 63 thus electrically shields the active gate 65 from the N-type drift region 52 (drain) and substantially reduces the gate-to-drain capacitance $C_{gd}$ between these two elements. This greatly improves the switching speed of the MOSFET as well as the response time of the MOSFET in linear applications.

**Fig. 6** illustrates the principles of this invention used in a Barrier-ACCUFET 6 of the kind described in the above-referenced Application No. 09/476,320. The doping of the drift region 72 between the trenches 71 and the width of the mesa between the trenches 71 are chosen in a way to assure a full depletion of the portion of the drift region 72 between the trenches 71 when Barrier ACCUFET 6 is turned off. This in turn, provides a current pinching effect in the drift region 72 and reduces the electric field at the PN-junction between the drift region 72 (drain) and the P-body region 53, allowing a shorter channel and less charge in the body region 53 without punchthrough behavior. Therefore, Barrier-ACCUFET 6 can be designed with a thicker gate oxide layer 66 and yet have a low threshold voltage equivalent to that of the trench-MOSFET 5 shown in **Fig. 5**.

In order to realize the current-pinching effect in the drift region 72 between the trenches, the height of the shield gate 75 should be to greater than 1/3 of the width M of the mesa. In the preferred embodiment the shield gate height is equal to about ½ M. The oxide layers 72 and 74 below and above the shield gate 73 are significantly thicker than the gate oxide layer 66 to further reduce the drain to gate capacitance.

As described in the above-referenced Application No. 09/476,320, the portion of the drift region 72 will be depleted when Barrier ACCUFET is turned off if the net charge density of N-type ions in the portion of the drift region 72 within the mesa is no greater than 5 x $10^{12}$ cm$^{-2}$, measured with reference to a plane perpendicular to the principal surface of the die 55 and calculated as an integral of the net doping concentration across the width M of the mesa. This allows the net charge density of P-type ions in the body region 53 to be less than the level that would normally be required to avoid punchthrough behavior. This level is generally accepted as being significantly higher than 1.5 x $10^{12}$ cm$^{-2}$, measured with reference to a plane parallel to the principal surface of the die and calculated as an integral of the net- doping concentration in the body region between (i) the PN junction between the N+ source region 54 and the P-body region 53 and (ii) the PN junction between the P-body region 53 and the N drift region 72 (drain).

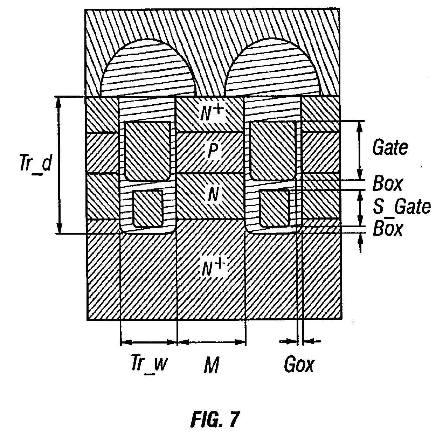

**Fig. 7** defines various dimensions of the Barrier ACCUFET 6 of **Fig. 6** as follows:

TR_w is the width of the trench.

Tr_d is the depth of the trench.

M is the width of the mesa.

Gox is the thickness of the gate oxide layer adjacent the channel region.

Gate is the depth of the active gate.

Box is the thickness of the bottom oxide layer as well as the thickness of the oxide layer between the active and shield gates.

S_gate is the depth of the shield gate.

Table 1 provides a comparison of the above parameters for prior art MOSFET 3 (**Fig. 3**), prior art MOSFET 4 (**Fig. 4**), MOSFET 5 (**Fig. 5**) and Barrier ACCUFET 6 (**Fig. 6**).

Table 1

| Device | Tr_w (µm) | Tr_d (µm) | M (µm) | Gox (Å) | Gate (µm) | Box (Å) | S_gate (µm) |
|---|---|---|---|---|---|---|---|
| Fig. 3 | 0.7 | 0.85 | 1.0 | 300 | 0.7 | | |
| Fig. 4 | 0.7 | 1.2 | 1.0 | 300 | 0.7 | 1000 | 0.2 |
| Fig. 5 | 0.7 | 1.2 | 1.0 | 300 | 0.7 | 1000 | 0.2 |
| Fig. 6 | 0.7 | 1.4 | 1.0 | 500 | 0.7 | 1000 | 0.4 |

The impact of the invention on the performance of the trench-MOSFETs will be illustrated with two application examples. The devices from Table 1 have been designed for a $V_{ds,max}$ rating of 20V.

RF-Amplifiers

The designers of RF-amplifiers for linear signal amplification demand transistors with high $g_{m,max}$ and low capacitances, resulting in a high gain, low distortion and high cut-off frequency of the amplifier. Table 2 compares the performance of the devices listed in Table 1 with the calculated performance of a Ma et al. device of the kind shown in Fig. 1 having a gate length of 0.6 µm and a gate oxide thickness of 250 Å.

Table 2

| Device | W (mm) | $G_{m,max}$ (mS) | $C_{rss}$ (pF) | $C_{iss}$ (pF) | $C_{oss}$ (pF) | $F_T$ (GHz) |
|---|---|---|---|---|---|---|
| Fig. 1 | 3.57 | 140 | 0.47 | 3.02 | 2.34 | 9.5 |
| Fig. 3 | 2.86 | 412 | 2.56 | 2.60 | 6.00 | 12.8 |
| Fig. 4 | 2.86 | 409 | 1.46 | 1.49 | 5.10 | 11.0 |
| Fig. 5 | 3.18 | 441 | 0.51 | 1.54 | 5.15 | 13.6 |
| Fig. 6 | 3.85 | 329 | 0.30 | 1.81 | 3.75 | 13.9 |

In Table 2, $g_{m,max}$ is the maximum transconductance calculated from the $I_{ds}(V_{gs})$ characteristics for $V_{ds}$=2V. The devices have been scaled to have the same maximum output current of 0.5A. The required channel width (W) has been calculated for each device using the maximum output current to be the $I_{ds,max}$ at which the transconductance $g_m$ drops by 10% from its maximum value. The capacitances have been calculated for the pre-determined channel width at bias conditions corresponding to an operational point of $V_{gs}=V_{ds}$=2V. The cut-off frequency $F_T$ is defined by:

$$F_T \equiv \frac{g_{m,max}}{2\pi c_{iss}}$$

The Barrier-ACCUFET device shown in Fig. 6 has the best overall performance, with a much lower feedback capacitance $C_{rss}$ and a much higher transconductance $G_{m,max}$ than the Ma et al. device of **Fig.1**.

DC/DC Converters

Table 3 shows a comparison of various parameters relevant to the operation of a switching transistor for a DC/DC converter.

Table 3

| Device | $R_{ds,on}$A $m\Omega/cm^2$ | $Q_g$/A $nC/cm^2$ | $C_{dg}$/A $nF/cm^2$ | $C_{iss}$/A $nF/cm^2$ | $C_{oss}$/A $nF/cm^2$ | $R_{ds,on}$ Qg $m\Omega nC$ |
|---|---|---|---|---|---|---|
| Fig.3 | 0.133 | 723 | 18.4 | 41.1 | 18.6 | 96 |
| Fig.4 | 0.135 | 606 | 13.9 | 35.9 | 14.0 | 82 |
| Fig.5 | 0.143 | 496 | 5.1 | 41.2 | 18.9 | 71 |
| Fig.6 | 0.192 | 306 | 3.1 | 37.2 | 19.8 | 59 |

The data in Table 3 have been calculated for the following conditions:

$R_{ds,on}$A for $V_{gs}$ =2.5V and $V_{ds}$=0.1V,

$Q_g$/A for $V_{gs}$=5V,

$C_{xx}$/A for $V_{gs}$=0V and $V_{ds}$=10V.

A figure of merit for high-frequency DC/DC converters is the product of specific on-resistance $R_{ds,on}$A multiplied by the gate charge ($Q_g$/A) required to charge the gate during turn-on ($R_{ds,on}$A • $Q_g$/A = $R_{ds,on}$ $Q_g$), which should be as low as possible. A Barrier-ACCUFET device designed according to the present invention (**Fig. 6**) shows the best performance also for applications in DC/DC-converters. The value of the figure of merit $R_{ds,on}$ $Q_g$ is reduced by 40% as compared to the conventional Trench-MOSFET of **Fig. 3** .

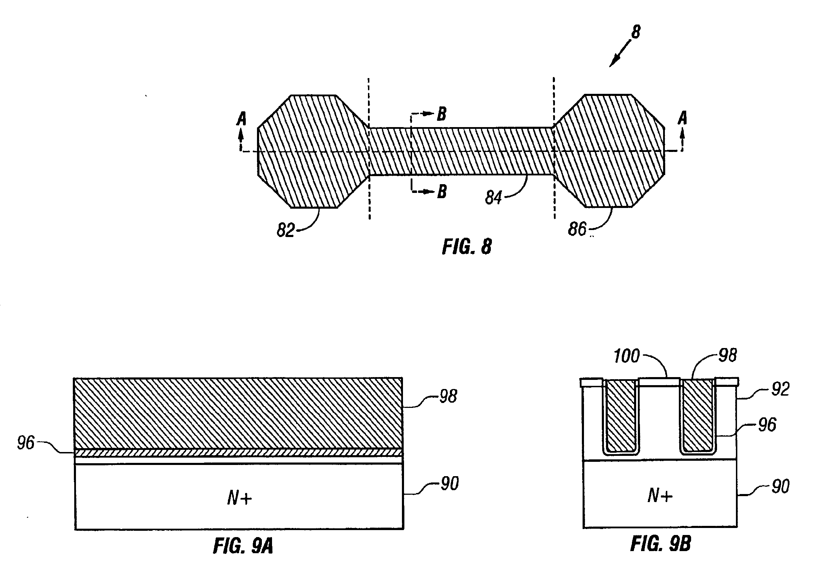

**Figs. 8** and **9A-9B** through **13A-13B** illustrate a process of fabricating a trench device in accordance with this invention.

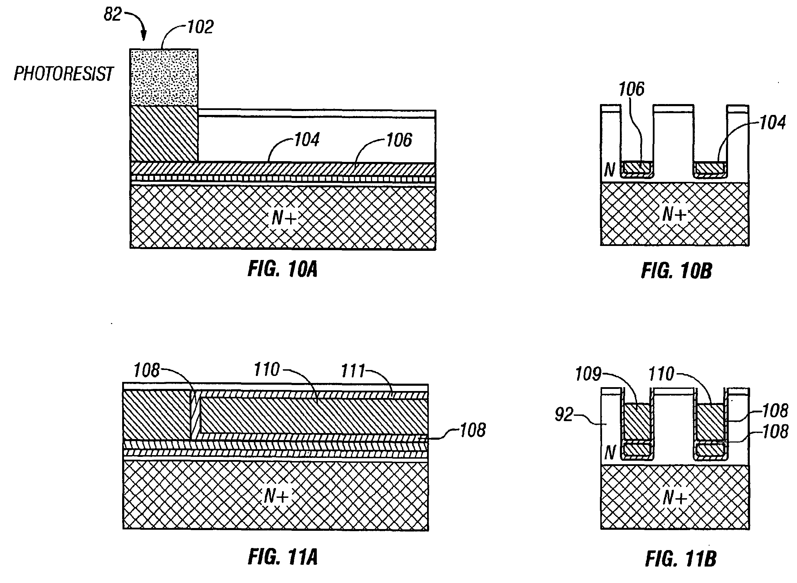

**Fig. 8** shows a top view of a segment of a trench 8 which could be part of any type of trench geometry, e.g., a striped cell or a closed cell design. Trench 8 includes shield gate contact region 82, an active device region 84, and an active gate contact region 86. In this embodiment, shield gate contact region 82 and active gate contact region 86 are somewhat wider than active device region 84, but this need not be the case in all embodiments. The cross-section lines labeled A-A and B-B identify the sections at which **Figs. 9A-13A** and **Figs. 9B-13B**, respectively, are taken, with one difference. It will be noticed that, while the cross-section B-B of **Fig. 8** crosses only a single trench, the cross-sections of **Figs. 9B-13B** show a pair of trenches on either side of a mesa.

The process flow presented in **Figs. 9** to **13** is based on a process flow used in a fabrication of a conventional Trench-MOSFET.

As shown in **Figs. 9A** and **9B,** the starting material is an $N^+$-substrate 90 with an N-type doped epitaxial layer 92. **Figs. 9A** and **9B** show the device after the trenches 94 have been formed in a conventional manner, which includes trench etch, rounding of the trench corners, and the deposition and removal of a sacrificial oxide along the walls and bottoms of the trenches. After the thermal growth of an oxide layer 96 on the walls and bottoms of the trenches and a deposition of a first, $N^+$-doped polysilicon layer 98, the polysilicon layer 98 is partially etched back so that the top surface is roughly at the level of the main surface of the epitaxial layer 92. An oxide layer 100 is grown on the surface of the mesa between trenches 94. In this embodiment the trench 94 does not extend entirely through the epitaxial layer 92, but in other embodiments the trench may extend into the substrate 90.

As shown in **Figs. 10A** and **10B,** a photoresist mask 102 is deposited and patterned to define the shield gate contact region 82, i.e., the area which will be used for a contact to the shield gate. The first polysilicon layer 98 is etched down to a pre-determined level which will be the top surface 104 of the shield gate 106 (**Fig. 10A**). The photoresist mask 102 is removed, and the oxide layer 96 is etched away from the trench side walls above the shield gate 106. The remaining portion of oxide layer 96 beneath the shield gate 106 will become the bottom oxide layer.

An oxide layer 108 is grown thermally on the top surface of the shield gate 106 and on the walls of the trenches 94 above the shield gate 106. Oxide layer 108 will become the gate oxide layer separating the active gate from the channel of the transistor and insulating the shield gate 106 from the active gate. A second N⁺-doped polysilicon layer 110 is deposited, providing the material for the active gate 109. The second polysilicon layer 110 is "over-etched" back until its top surface is below the top surface of the epitaxial layer, within the trenches 94 (**Fig. 11B**). The over-etch time is used to minimize the final overlap of the active gate with the source region. A thick oxide layer 111 is formed on top of the active gate 109.

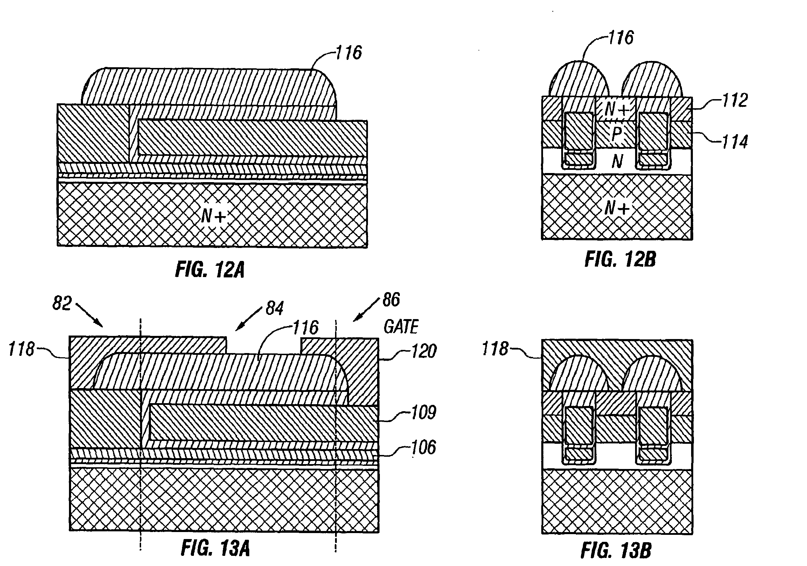

The rest of the process follows the conventional process flow. As shown in **Fig. 12B**, P-body regions 114 and N+ source regions 112 are formed by implantation and annealing. A BPSG-layer 116 is deposited and contact windows are etched using an appropriate mask. As shown in **Fig. 13A,** the shield gate 106 is contacted by metal contact 118 in the shield gate contact region 82, and the active gate 109 is contacted by metal contact 120 in the active gate contact region 86.

A metal layer is deposited and patterned using an appropriate mask. As shown in **Figs. 13A** and **13B**, metal contact 118 forms a contact to both the shield gate 106 and the N+ source regions 112. Metal contact 120 contacts only the active gate 109.

The specific embodiments described herein are intended to be illustrative only and not limiting. Many alternative embodiments will be obvious to persons skilled in the art from the embodiments described herein.

**Claims**

**1.** A trench MOSFET comprising:

a semiconductor die having a trench formed in a principal surface of the die, the semiconductor die containing:

a source region of a first conductivity type located adjacent a side wall of the trench and the principal surface;

a body region of a second conductivity type located adjacent the source region and the side wall of the trench; and

a drain region of the first conductivity type adjacent a bottom of the trench;
the trench containing:

a first insulating layer adjacent the bottom of the trench;

a conductive shield gate overlying the first insulating layer and connected to a constant voltage source;

a second insulating layer overlying the conductive layer; and

a conductive active gate overlying the second insulating layer.

**2.** The trench MOSFET of Claim 1 wherein the shield gate comprises polysilicon doped with positive or negative impurity atoms.

**3.** The trench MOSFET of Claim 1 or 2 wherein the shield gate is connected to the source region.

**4.** The trench MOSFET of Claim 1, 2 or 3 wherein the first insulating layer comprises an oxide.

**5.** The trench MOSFET of Claim 2, 3 or 4 wherein the second insulating layer comprises an oxide.

**6.** The trench MOSFET of Claim 1, 2, 3, 4 or 5 wherein the trench comprises a gate insulating layer adjacent the body region at a side wall of the trench.

**7.** The trench MOSFET of Claim 6, 7 or 8 wherein the second insulating layer has a thickness that is greater than a thickness of the gate insulating layer.

**8.** The trench MOSFET of Claim 9 wherein the second insulating layer is at least twice as thick as the gate insulating layer.

9. The trench MOSFET of Claim 6, 7 or 8 wherein the first insulating layer has a thickness that is greater than the thickness of the gate insulating layer.

10. The trench MOSFET of Claim 7, 8 or 9 wherein the first insulating layer is at least twice as thick as the gate insulating layer.

11. The trench MOSFET of Claim 9 wherein the trench comprises a fourth insulating layer adjacent the conductive shield layer and the drain region.

12. The trench MOSFET of Claim 11 wherein the fourth insulating layer has a thickness that is greater than the thickness of the gate insulating layer.

13. The trench MOSFET of Claim 1 wherein the trench comprises first and second sections which define a mesa.

14. The trench MOSFET of Claim 13 wherein a portion of the drain region within the mesa is depleted when the trench MOSFET is turned off.

15. The trench MOSFET of Claim 13 wherein the drain region comprises a heavily-doped region and a lightly-doped drift region.

16. The trench MOSFET of Claim 15 the drift region extending into the mesa, a portion of the drift region within the mesa being depleted when the trench MOSFET is turned off.

17. The trench MOSFET of Claim 15 wherein the net charge density of ions of the first conductivity type in the portion of the drift region within the mesa is no greater than $5 \times 10^{12}$ cm$^{-2}$, measured with reference to a plane perpendicular to the principal surface of the die and calculated as an integral of the net doping concentration across the mesa from the first section to the second section of the trench.

18. The trench MOSFET of any one of the preceding claims wherein the net charge density of ions of the second conductivity type in the body region is no greater than $1.5 \times 10^{12}$ cm$^{-2}$, measured with reference to a plane parallel to the principal surface of the die and calculated as an integral of the net doping concentration in the body region between a PN junction between the source and body regions and a PN junction between the body and drain regions.

19. A method of fabricating a MOSFET in a semiconductor die comprising:

    forming a trench in the semiconductor die, the trench comprising a shield gate contact region, an active device region, and an active gate contact region;

    forming a first insulating layer at a bottom of the trench;

    introducing a first layer of conductive material over the first insulating layer;

    forming a mask over the first layer of conductive material in the shield gate contact region;

    etching the first layer of conductive material in the active device and active gate contact regions;

    forming a second insulating layer over the first layer of conductive material in the active device and active gate contact regions;

    introducing a second layer of conductive material in the active device and active gate contact regions, the second layer of conductive material being insulated from the first layer of conductive material;

    connecting the first layer of conductive material to a constant voltage; and

    connecting the second layer of conductive material to gate drive circuitry.

20. The method of Claim 19 wherein the constant voltage is ground.

**21.** The method of Claim 19 wherein the constant voltage is a constant DC voltage.

**22.** A method of fabricating a MOSFET in a semiconductor die comprising:

forming a trench in the semiconductor die, the trench comprising a shield gate contact region, an active device region, and an active gate contact region;

growing an oxide layer on a side wall and a bottom of the trench;

depositing a first polysilicon layer in the trench;

forming a photoresist mask layer over the first polysilicon layer in the shield gate contact region;

etching the first polysilicon layer in the active device and active gate contact regions such that a surface of the first polysilicon layer is located inside the trench;

growing a second oxide layer over the first polysilicon layer in the active device and active gate contact regions;

growing a gate oxide layer in the active device region;

depositing a second polysilicon layer over the first polysilicon layer in the active device and active gate contact regions;

forming a body region in the semiconductor die adjacent the gate oxide layer; and

forming a source region in the semiconductor die.

**23.** The method of Claim 22 comprising connecting the first polysilicon layer to a constant voltage.

**24.** The method of Claim 22 comprising connecting the first polysilicon layer to the source region.

**25.** The method of Claim 22 comprising connecting the second polysilicon layer to gate drive circuitry.

FIG. 1
(Prior Art)

FIG. 2
(Prior Art)

EP 1 170 803 A2

SOURCE

39

38
37
GATE
36
35

N+

N+

P

41
N

34
33
31
32

30

DRAIN

**FIG. 3**
**(Prior Art)**

SOURCE

39

45

43

41

GATE

42

N+

P

N

44

N+

34
33
32

30

FLOATING GATE:
UNDOPED
POLYSILICON

41

40

40

DRAIN

**FIG. 4**

60
55
54
53
51
52
50

SHIELD GATE: DOPED POLYSILICON

SOURCE

N+  P-64  N  N+

GATE

51

62

51

DRAIN

58
65
66
63
59

**FIG. 5**

60
54
53
72
50

SHIELD GATE: DOPED POLYSILICON

M

SOURCE

N+  P-74  N

GATE

72  N+ 71

71

DRAIN

66
65
75
73
59

**FIG. 6**

12

EP 1 170 803 A2

**FIG. 7**

FIG. 8

FIG. 9A

FIG. 9B

EP 1 170 803 A2

PHOTORESIST

82
102
104 106
N+

**FIG. 10A**

106
104
N
N+

**FIG. 10B**

108 110 111
108
N+

**FIG. 11A**

109 110
92
108
108
N
N+

**FIG. 11B**

FIG. 12A

FIG. 12B

FIG. 13A

FIG. 13B

EP 1 170 803 A2